# EUROPEAN PATENT SPECIFICATION

(11) **EP 0 493 876 B1**
(45) Date of publication and mention of the grant of the patent: **05.08.1998**
(21) Application number: 91309728.3
(22) Date of filing: 22.10.1991
(51) Int. Cl.: G06F 15/16, G06F 15/80

(54) **Reducing circuit path crossovers in stacked multiprocessor board arrays**
Verminderung von Verdrahtungskreuzungen in gestapelten Multiprozessorleiterplatten
Réduction des croisements de chemin entre circuits dans des arrangements de circuits multiprocesseur empilés

(30) Priority: 31.12.1990 US 636323
(43) Date of publication of application: 08.07.1992
(73) Proprietor: AT&T Corp., New York, NY 10013-2412 (US)
(72) Inventor: Segelken, John Maurice, Morristown, New Jersey 07960 (US); Shively, Richard Robert, Convent Station, New Jersey 07961 (US); Stanziola, Christopher Anthony, Hyde Park, New York 12538 (US); Wu, Lesley Jen-Yuan, Denville, New Jersey 07834 (US)
(74) Representative: Buckley, Christopher Simon Thirsk

(56) References cited:
- PROCEEDINGS SUPERCOMPUTING '89 13 November 1989 , RENO, USA pages 505 - 509 R. SHIVELY ET AL 'A high performance reconfigurable parallel processing architecture'
- RECHERCHE, LA vol. 20, no. 208 , March 1989 , PARIS FR pages 420 - 421 J. F. COLONNA 'L' ordinateur à l' assaut de la troisième dimension'

## Description

One form of multiprocessor computer architecture consists of stacked multiple printed circuit boards, each board containing several computing nodes. When a computing node includes multiple chips for performing processing, memory, communications and other functions as needed, the node may be referred to as a "multi-chip module," or "MCM."

Typically, although not necessarily, an MCM is formed with a surface geometry of a rectangle or, more usually, a square. The choice of a square surface geometry is influenced by conventional design, fabrication and MCM interconnection technology. In this typical configuration, each of the four edges of each MCM serve as a port, where a multiplicity of signal wires to and from the MCM are routed. The ports typically are denoted north, east, west and south. The ports physically are a linear array of contact pads disposed along the MCM edge, to a density typically of 125 pads per running inch.

One way to realize useful arrays of MCMs is to mount, for example, four square-shaped MCMs on an individual 4-sided metal core board. In addition to providing a mounting substrate for the MCMs, the metal core board provides linear fields of contact pads corresponding to the contact pads along the four sides of the MCM, and electrical connections, selectively as needed, between the MCM contact pads and the board contact pads. The latter contact pads provide the means for connecting the MCM ports on each board to the "outside world," including the MCMs located on boards at other layers in the stack, and a Host computer.

A preferred approach for stacking and electrically connecting the boards of a stacked array is described, for example, in the earlier patent application of the present applicants, serial number 07/590246, filed September 28, 1990, now US-A-5420754.

The complexities of the computer architecture formed by the MCMs in the stacked board arrays require a very large number of necessary signal paths. These signal paths are formed and routed on the MCMs themselves, as well as between MCMs on the same board level and MCMs which are located on boards disposed at other levels in the stack.

Large numbers of signal paths greatly increase the incidences of path "crossover" points. Crossover points occur both within the MCM and on the metal core board. Since the paths at cross-over points must not electrically contact one another, board and MCM design strategies must be used to prevent interfering electrical contact between crossing paths.

The typical expedient is to re-route one of the paths to a different layer and thus "cross over" the first path in a different plane. This approach requires "vias," or vertical interconnections fashioned as plated-through holes; lased vias (sometimes termed "microwire"); or microvias. These interconnections join the upper and the lower level of the circuit, wherein one of the interfering circuit paths is connected to the top end of the via. The path is continued through to the bottom end of the via, where a connection is made to a continuation path formed on the underside of the device, substrate, or the board as the case may be.

Vias on the mounting board, however, detract from the very limited surface area needed for running circuit paths. Vias also add more detail to the board. Thus, an excess of vias creates increased board size and/or number of layers; and adds substantially to production costs. When vias are implemented as plated-through holes, they increase total area requirements because of the added land area and clearance area required; and also can decrease board yield. The vias here also reduce the heat dissipation of the board by detracting from the metalization layer.

The efficient routing of signals in the stacked board configuration such as is described in the noted patent application, therefore, has been difficult to achieve because of the lack of a way to minimize the number of vias on the metal core board.

According to one aspect of this invention there is provided a stacked multiprocessor board array as claimed in claim 1.

According to another aspect of this invention there is provided a stacked multiprocessor board array as claimed in claim 6.

Advantages of embodiments of the invention may include improved routing of signals in stacked-board multiprocessor configurations, a reduction in the routing path crossovers in such arrays, as well as the complexities that accompany the including of via routing paths, and taking advantage of the inherent geometry of current stacked-board multiprocessor configurations to reduce the number of signal routing crossovers while at the same time reducing the length of the routing paths.

The invention originates in part from a realization that the routing densities achievable on the MCM are both higher and more cost-effective than can be achieved on the metal core mounting board. Additionally, less parasitic capacitance is created by locating routing paths, where possible, on the MCM. Therefore, the placement of routing circuitry may be both concentrated advantageously on the MCMs, and also configured advantageously at the MCM contact pads.

Proceeding from this realization, the invention involves reducing the number of circuit path crossover points that would otherwise be required on the mounting board. This is achieved by mounting the MCMs on the board in such a way that their north-east-south-west ports are successively reordered to N-S-E-W. The reordering places the ports out of their normal N-E-S-W orientation practiced in the prior art; and provides for all MCMs a common bus structure located at a common interior area of the mounting board, to which the E-and W-ports are oriented. In the new orientation, the N- and S-ports are disposed in different planes, for example, the N-port is above-board and the S-port is below board. The E- and W-ports are on the same board or plane.

In one illustrative embodiment of the invention, four square-shaped MCMs are mounted on a metal core board with the aforementioned reordered port orientation, achieved by rearranging the internal circuitry in each individual MCM. Additionally, the MCMs are rotated relative to each other in this embodiment by increments of 90°. This helps reduce the number of crossovers on the metal core board. The specific rearrangements continue to follow a basic convention of connecting N to S, and E to W, while, pursuant to the invention, the number of crossovers needed to be formed external to the MCMs on their mounting board are reduced or in some instances eliminated altogether.

The inventive concept is applicable beyond an assembly of a set of four 4-sided MCMs on a mounting board used in the example. The invention will be seen to be applicable to a definable class of multi-sided multi-chip modules on a board, wherein crossover points can be minimized through rotation of the MCMs and reordering of the orientation of the ports of the MCMs. Further, the invention is applicable to 4-sided MCMs which are designed to have, for example, eight ports with two ports disposed on each edge.

### DESCRIPTION OF THE DRAWING

FIG. 1 is an exploded schematic perspective diagram of a typical stack of board-mounted MCMs;
FIG. 2 is a top view of a board mounting MCMs;
FIG. 3 is a partial copy of several superposed masks of the routing connections on a typical MCM;
FIGS. 4 and 5 are schematic top views of prior art board-MCM wiring plans, showing crossover areas;
FIG. 6 is a schematic top view of a board-MCM wiring plan using the invention;
FIG. 7 is a schematic top view of a board embodying the invention of FIG. 6, showing further routing innovations;
FIG. 8 is a schematic perspective diagram of the invention applied to a multilayer stack of boards,
FIG. 9 is a perspective view depicting an alternative form of board and MCM to which the invention is applicable, and
FIG. 10 is a perspective view of a further alternative shape of MCM.

### DETAILED DESCRIPTION OF ILLUSTRATIVE EMBODIMENTS

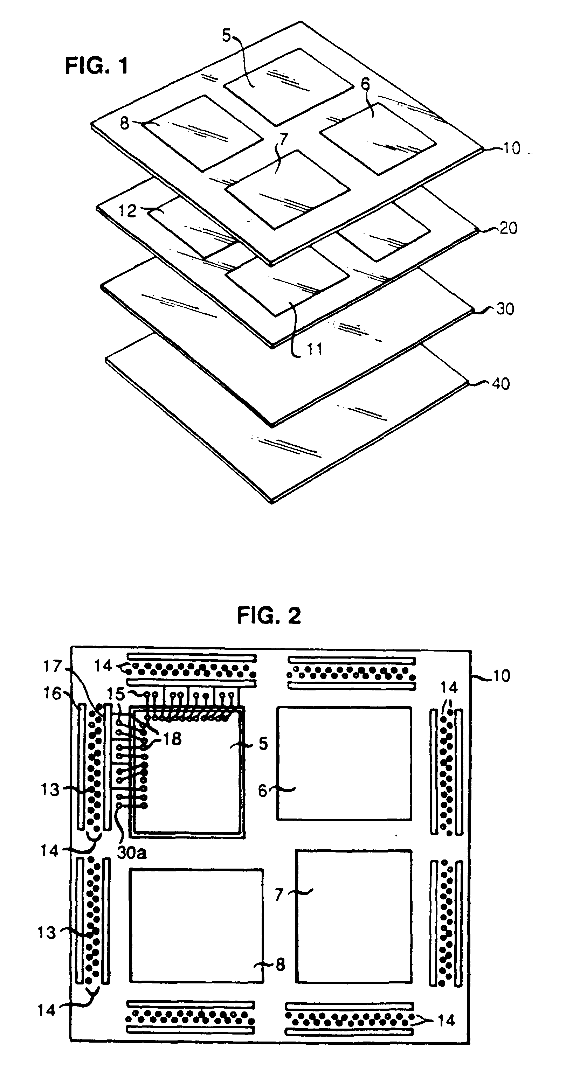

FIG. 1 shows schematically a stack of metal core boards denoted 10, 20, 30, 40, arrayed in exploded view for illustration. On each board are mounted four multi-chip modules (as above, "MCMs"), these being denoted 5, 6, 7, 8 for the board 10. The boards 20, 30 and 40 also each have MCMs mounted as on board 10, such as the MCMs denoted 9, 11 and 12 on board 20. For simplicity, the MCMs associated with the boards 30, 40 are not shown in FIG. 1. Further structural details of the boards 10, 20, 30, 40, and MCMs 5-8, and of the stacking assembly, are contained in the above-cited US-A-5420754. The board 10 is metal cored to extract heat, by conduction to an outer perimeter region where convective heat transfer occurs as taught, for example in the patent application of Y. C. Lee and J. M. Segelken, serial number 07/387480, filed July 28, 1989, now US-A-5049982. This patent application to the extent relevant is incorporated by reference.

Referring to FIG. 2, contact pads formed on board 10, such as pad 13, are arrayed in fields denoted 14. The regions 16, 17 denote conventional surface metalization explained in the cited. US-A-5420754. On the board 10, adjacent to each of the four outwardly-facing sides of each MCM 5, 6, 7, 8 are formed MCM connect pads 15. Wire bonds connect from contacts 18 on the MCMs to contacts 15 on board 10.

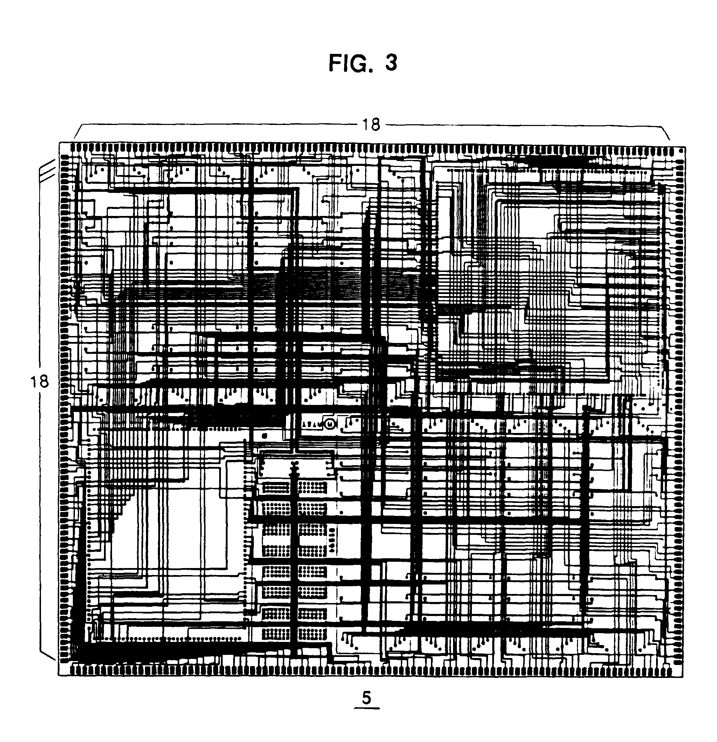

As noted earlier, circuit path crossover points have presented problems in the structures illustrated in FIGS. 1 and 2. Specifically, the routing paths which culminate in contacts 18, best seen in FIG. 3, which provide connection to and from the MCMs 5, 6, 7, 8, must ultimately connect to the "outside world," such as to a Host computer or other instrumentality. The contacts 18 are located along each of the four sides of the MCM 5. FIG. 3 is provided to show the very large number of connections needed to the outside world from the internal circuitry of the MCM 5. Each of the contacts 18 detailed in FIG. 3, must be connected by a path to the outside world. FIG. 3 also is a specific example of the routing density achievable on the MCM.

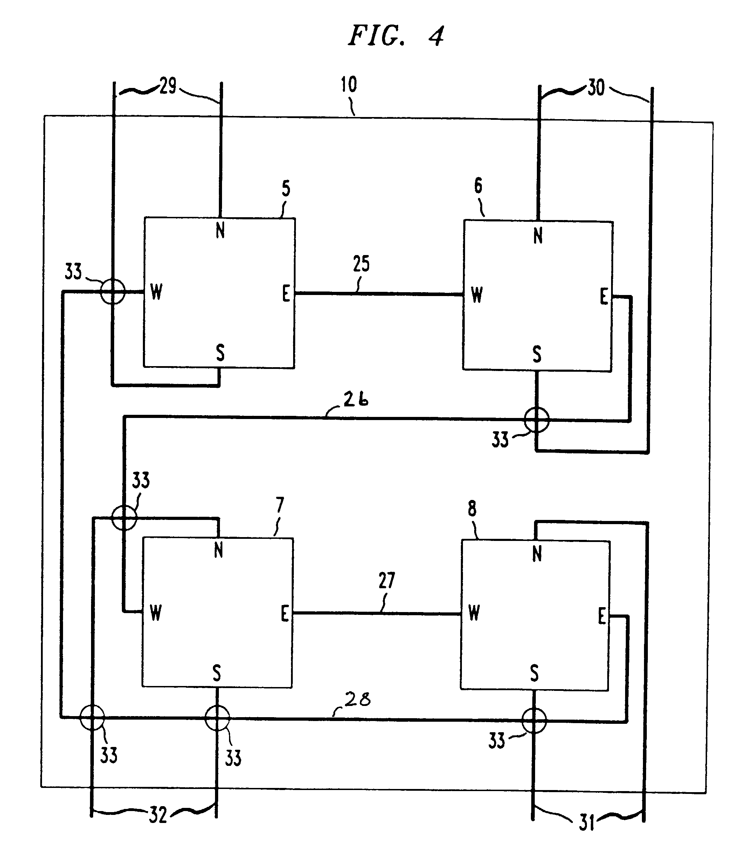

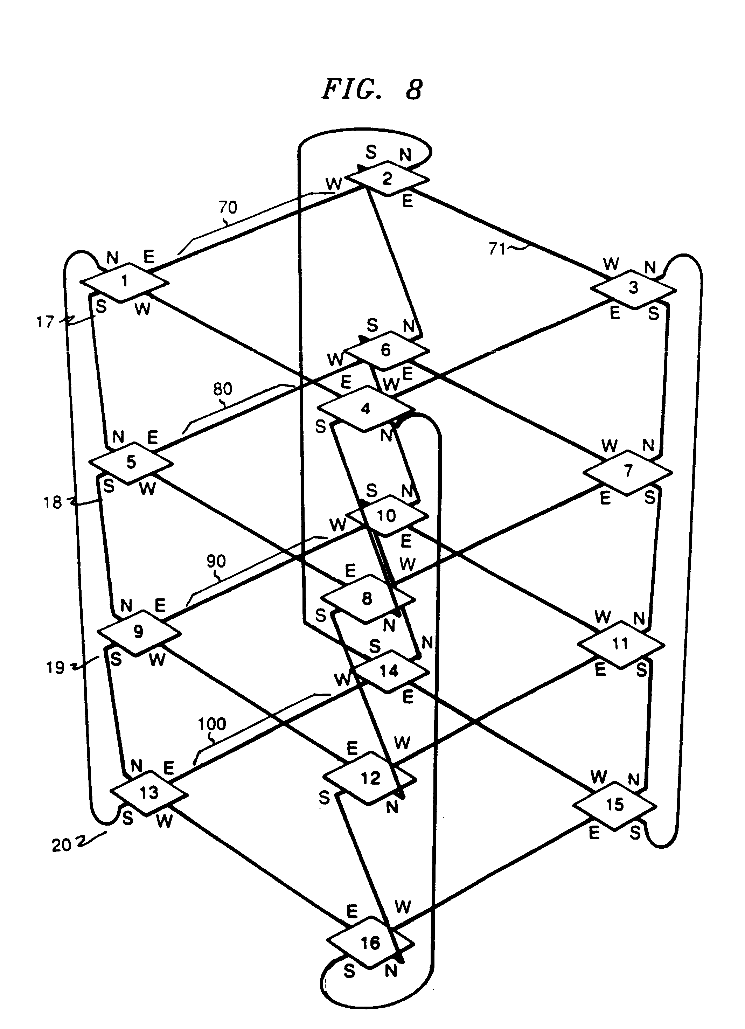

FIG. 4 is a first simplified sketch showing of the character of the prior art crossover problem. In contrast to FIG. 3, in FIG. 4, only one circuit path instead of 100 (for example) is actually shown which connects the "north, east, south and west" ports or sides of four MCMs bounded on a board. In this example, it will be noted that the sequence of MCMs, starting clockwise from the top left is: MCMs 5, 6, 8, 7; and further, for each said MCM, the port configuration is the conventional N-E-S-W. In this configuration, the N- and S- ports are connected to other boards in the manner shown, for example, in FIG. 8, wherein the N-port is disposed on the top surface of board 10, and the S-port is routed to the bottom surface of the board beneath the corresponding N-port. The nomenclature used in FIG. 4 is adapted from FIGS. 1 and 2, wherein the MCMs are denoted 5, 6, 7, 8 and their board is denoted 10. For illustration, the connections among the ports N, E, S, W, of the respective MCMs are those needed to configure a torus architecture which is more fully described in the cited US-A-5420754. The convention of connecting N to S, and E to W, is shown.

Specifically in FIG. 4, paths 25, 26, 27 and 28 achieve the E to W connections; and paths 29, 30, 31, and 32 achieve the N to S connections which, as noted, go to adjacent boards in the stack. Paths 29N, 30N, 31N, and 32N are on the board top surface and connect to the S-ports in the next-higher board (see FIG. 8).

It will be noted that the preceding connections are effected by circuit paths contained on board 10 as opposed to their being contained on the MCMs 5, 6, 7, 8. The connections require that crossover vias, schematically indicated by the encircled areas 33, be provided where the E- or W-paths intersect the N- or S-paths. Six such areas 33 are shown in the illustration, all requiring crossover vias.

In connection with FIG. 4, it will be appreciated that the number of crossover vias necessary at position 33 is not simply the one exemplified, but rather number up to 100, one for each active one of the contacts 18.

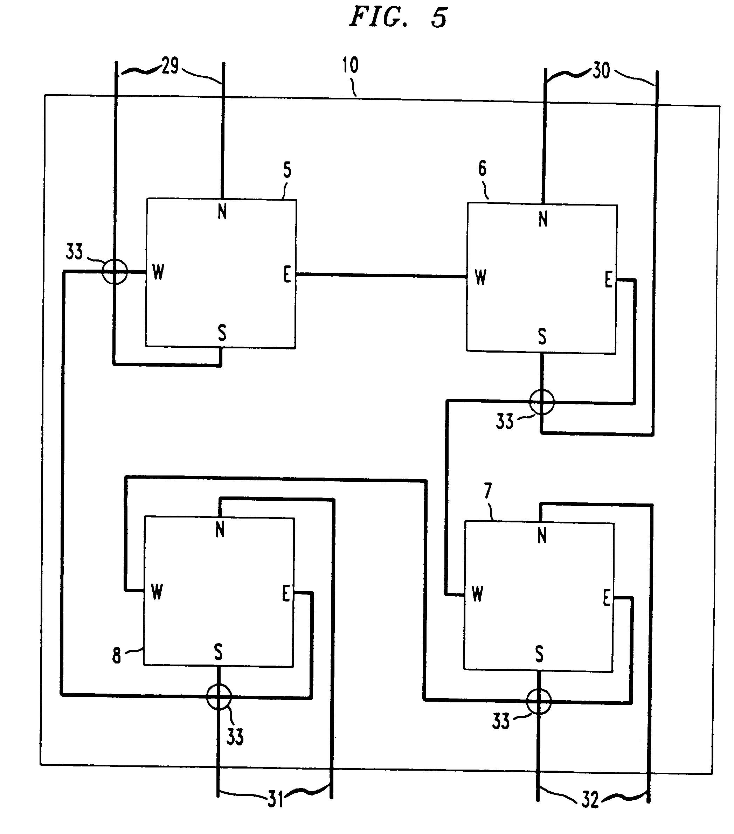

FIG. 5 is another simplified sketch showing a further example of the conventional crossover problem encountered in the prior art. FIG. 5 is similar in configuration to FIG. 4, except that the locations of the MCMs starting at the top and going clockwise, is: 5, 6, 7, 8. The change does reduce the number of crossover areas to four, from the six noted in FIG. 4; but four areas are still far too many.

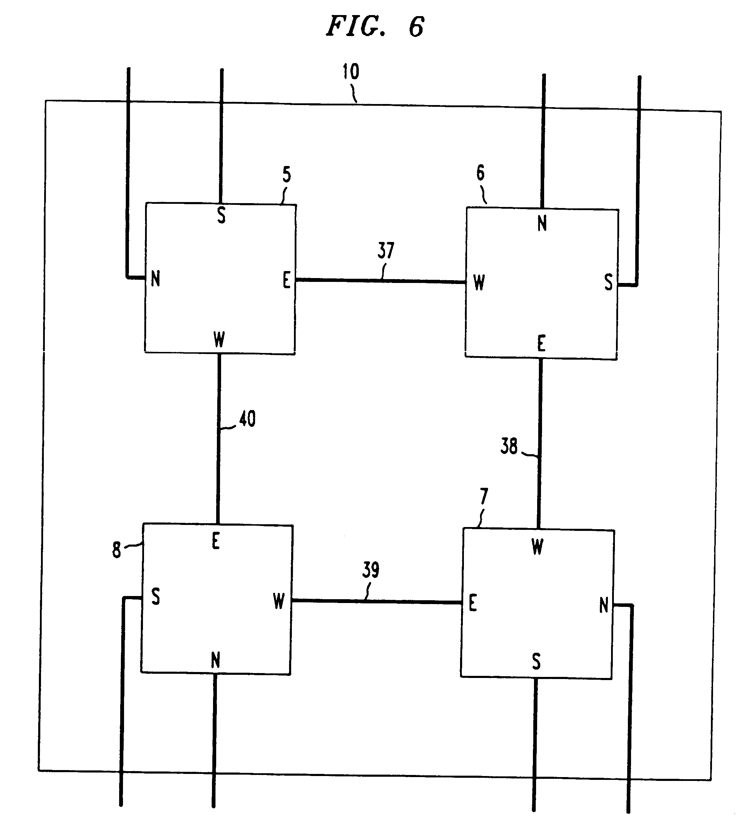

The invention will now be illustrated by reference to FIG. 6, in which the ports of the MCMs 5, 6, 7, 8 are reordered and a 90° phased rotation of the individual MCMs is effected. Specifically, E and W ports of the individual MCMs are re-routed as necessary within the MCMs, resulting in the E and W ports facing inwardly and toward each other. As with the configuration of FIG. 4, the E-W port connections 5E-6W, 6E-7W, 7E-8W and 8E-5W are maintained by the respective paths 37, 38, 39, 40. However, it is seen that there are now no crossovers of any of the N-S paths by the E-W paths 37-40. It will also be noted that the E-W paths achieved pursuant to the invention are more direct and therefore shorter than in the prior art boards of FIGS. 4 and 5.

In consequence of the invention, the bus structure which accesses the MCM board stack for communications and command signals can be improved. Specifically, for the computer architecture achieved by the herein-described basic 4-sided board 10 which mounts four square or rectangular-shaped MCMs each with N, E, S, W ports, further advantage may be taken of the invention when adding essential common busses on the MCMs.

As is known to persons skilled in the art of multiprocessor computer configurations, it is necessary for the Host computer to be able to communicate directly and essentially simultaneously with each of many computing nodes. This is accomplished advantageously by providing communications channels from the Host to all nodes, which channels are separate from the N-S and E-W internode connections described above. The communications channels are used to download signal pattern data, processing instructions and reporting instructions to the individual nodes.

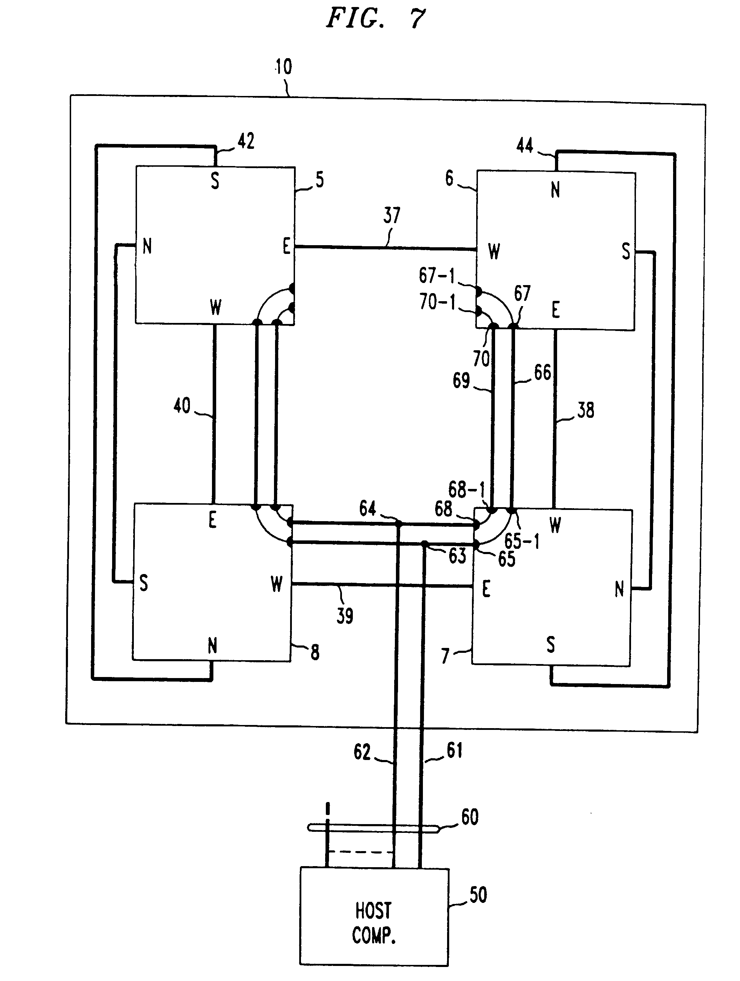

The Host communications connections to the MCMs are advantageously placed at the interior-facing corners of a 4-MCM structure as illustrated in FIG. 7. The question of how best to bring each communications path from the "outside world" represented by Host computer 50, to the boards such as board 10, and thence to these interior corners of the MCMs 5, 6, 7, 8, is next addressed.

FIG. 7 illustrates an efficient way to add communications busses to the structure of the general type depicted in FIG. 6. The group 60 of communications paths from a Host computer 50 includes paths 61 and 62 for illustration. These paths serve the MCMs of board 10, it being understood that in reality ten or twenty communications paths may be needed to serve board 10.

Like the MCM port connections, the communications paths 61, 62 must be routed into board 10 so as to avoid creating crossover points as much as possible. Pursuant to this, the paths 61, 62 are continued onto board 10 on the underside thereof, as illustrated by the dotted lines in FIG. 7, thereby crossing under the path 39 between ports 7E-8W. Paths 61, 62 thereafter are connected to two vias, 63, 64. It will be seen shortly that just one via is needed to bring each path such as path 61 to communications contact pads at the corners of the MCMs 5,6,7,8.

Path 61 connects through via 63 to the top side of board 10, and then continues on the top side of the board to connect to pad 65 on MCM 7. An internal path in MCM 7 is provided from pad 65 on the east port to a "duplicate" pad 65-1 on the west port. A connecting path 66 is made on board 10 from pad 65-1 to pad 67 at the east port of MCM 6; and an internal connection is made from pad 67 to a duplicate pad 67-1 on the west port of MCM 6. It will be noted that, due in substantial part to the connections made internally in the MCMs, no path crossovers are necessary.

Path 62 connects through via 64 to the top side of board 10, and then continues on to connect to pad 68 on MCM 7. Another internal connection in MCM 7 is provided from pad 68 to pad 68-1 on the west port. A connecting path 69 is provided from pad 68-1 to pad 70 on the east port of MCM 6. An internal connection is made from pad 70 to a duplicate pad 70-1 on the west port of MCM 6. Again, no path crossovers are created because the paths 66 and 69 do not interfere with each other, nor with the inter-MCM path 38.

The practitioner can readily appreciate that in a similar fashion, the paths 61, 62 are extended to communications contact pads shown (but not numbered) on MCMs 8 and 5. Again it is seen by reference to FIG. 7 that no crossover points are created with these extensions.

FIG. 8 illustrates the application of the invention to a stacked array of boards. The configuration of connected MCMs shown in FIG. 8 is a Torus. MCMs denoted 1, 2, 3, 4 are mounted on a board 70 which is shown only in partial phantom view for clarity. Board 70 is similar to board 10 seen in FIG. 5. Similarly, MCMs 5, 6, 7, 8 are mounted on a board indicated as 80; MCMs 9, 10, 11, 12 are mounted on a board indicated as 90; and MCMs 13, 14, 15, 16 are mounted on a board indicated as 100. Each of the MCMs have ports designated N, E, S, W.

FIG. 8 illustrates that the convention of connecting E-ports to W-ports, and N-ports to S-ports, is maintained. At the same time, crossovers in connecting E-W ports of adjacent MCMs are avoided. Thus, for example, the E-port of MCM 2 connects directly via circuit path 71 to the W-port of MCM 3. All of the remaining three connections of E-to-W ports on board 10 likewise are connected without occasioning crossovers. Further, the E-W port connections of the four MCMs on each of the respective boards 80, 90, 100, are connected without requiring crossovers. The avoidance of crossovers is achieved by reordering and rotating the ports of respective adjacent MCMs on each board so that all E and W ports face inwardly toward a common central board sub-area, and each E-port is directly facing a corresponding W-port. The convention of connecting N-to-S ports likewise is maintained in the assembly shown in FIG. 8. Methods for specifically effecting these N-S connections are contained in the cited US-A-5420754.

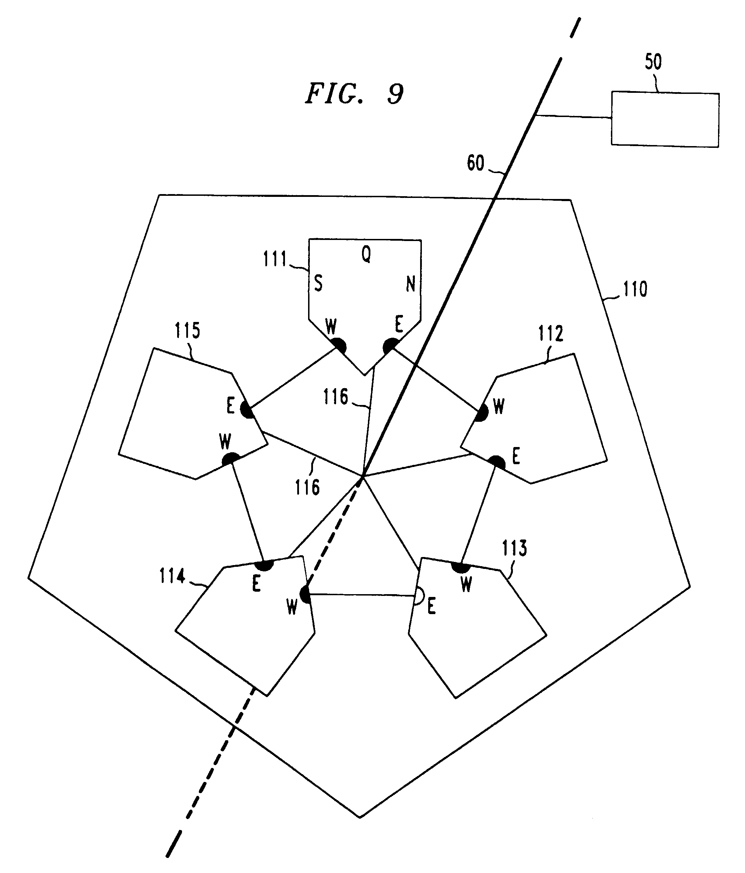

FIG. 9 shows that the invention may be applied to board-MCM configurations other than those having four 4-ported MCMs mounted on a 4-sided board. As seen in FIG. 9, a 5-sided board 110 mounts five MCMs 111, 112, 113, 114, 115, each of which are 5-ported. For example, MCM 111 included ports E, W, N, S and Q. Ports N, S and Q may be connected in various configurations; but importantly, it is seen that ports E and W are connected, so that all E and W ports face inwardly toward a common central board sub-area, and each E-port is directly facing a corresponding W-port. FIG. 9 also illustrates that a communications path 60 from a Host computer 50 can be introduced in a vertical run to a center location of board 110, from which communications links 116 are placed to pads 117 on each of the MCMs 111-115.

The embodiment of FIG. 9 depicts a 5-sided MCM and a 5-sided board mounting five such MCMs. It is apparent, however, that the same basic scheme of inwardly-facing E-W ports accessed by a common bus and communicating through direct E-W connections not requiring crossovers, can be achieved for a 6-sided MCM and 6-sided mounting boards. In general, an n-sided MCM and an n-sided board mounting n MCMs, where n is 4 or more, is contemplated within the scope of the invention.

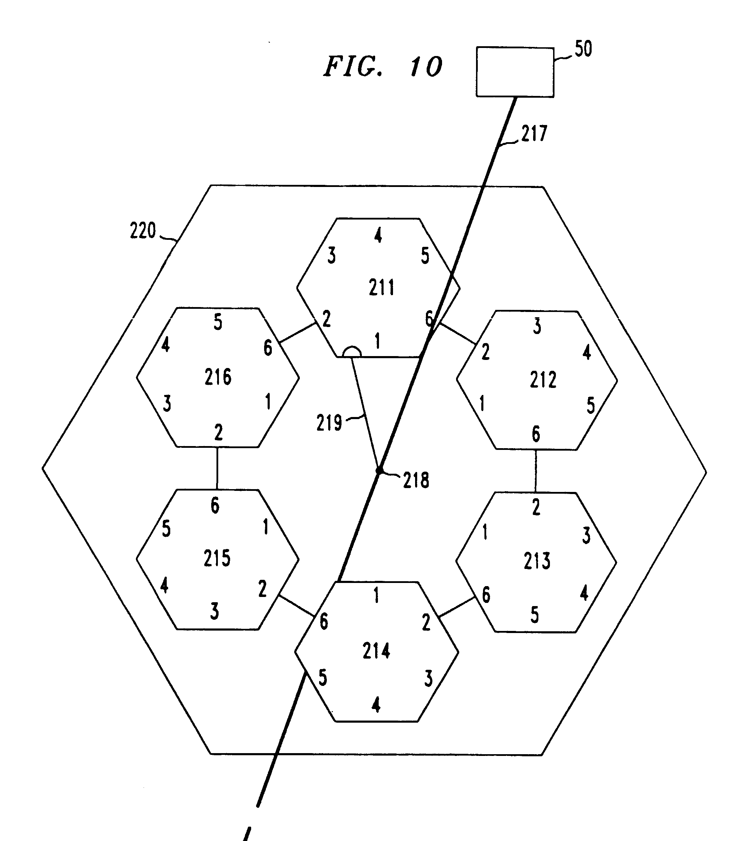

FIG. 10 shows a further configuration of MCMs, this time produced by six congruent regular hexagonal MCMs denoted 211, 212, 213, 214, 215, 216. The MCMs are mounted on a board 220. Each MCM has ports designated 1, 2, 3, 4, 5, 6. A communications link 216 from a Host computer 50 connects at a point 218 essentially in the center of the common area in a path which is run generally vertically to the board 220. A buss path 219 is provided from link 216 to MCM 211. Further bussing to and between the MCMs may be provided either directly from area 218, or in paths that are parallel to the 2-to-6 port linkage path. Several boards 220 with MCMs may be stacked and so linked.

Each successive MCM is mounted on the board in an orientation that is rotated or phased by 60 degrees relative to either of its neighbors. In this configuration, the 1-ports of the MCMs always face inwardly and toward a central common area The 2- and 6-ports always face each other, providing the constant E-W connection between adjacent MCMs of the type illustrated earlier. The 3-, 4-, and 5-ports always face outwardly. It also will be appreciated that the MCMs of FIG. 10 might be configured in a tight mosaic wherein the sides containing the ports 2 and 6 actually touch, to pack more MCMs into a given limited space on board 220.

## Claims

1. A stacked multiprocessor board array comprising plural multichip modules (1-16) mounted on plural boards (70, 80, 90, 100), each said module having a substantially rectangular surface geometry and, within said module, a multiplicity of internal circuit paths interconnecting multiple chips, each of the four edges of each module comprising a discrete plurality of circuit path terminations (18) selectively connecting to circuits in said multiple chips, the edges thereby constituting north (N), east (E), south (S) and west (W) ports to said module, and said ports of each module having a nominal assigned edge position of north, east, south and west, going clockwise, and routing paths (37-40) connecting the east and west ports of said modules, and routing paths (29-32) connecting the north and south ports of said modules, said stacked multiprocessor board array being characterized in that the specific physical location of each said routing path on each of said plural boards is determined by reordering the nominal north, east, south and west ports of each said module so that the east and west ports are adjacent on each module, and successively rotating each said module to cause the now-adjacent east and west ports to face inwardly toward each other and onto a common board area.

2. An array in accordance with claim 1, wherein the number of said modules mounted on each said board is four.

3. An array in accordance with claim 2, comprising:
a common communications bus structure for said four modules, said structure being located at said common interior area of said board and comprising:
a communications access path group (60) routed under one of said east-west port connections (39) and into said common area on said board, and
means comprising parallel paths (66,69) interior to said east-west port connections for extending said access path group to each of one of said modules.

4. An array in accordance with claim 2 or 3, comprising a plurality of routing paths formed on said boards between the north and south ports of adjacent modules.

5. An array in accordance with claim 2 or 3, wherein two of said modules (7,8) are interchanged in position with respect to their nominal original position.

6. A stacked multiprocessor board array comprising:
plural multichip modules (111-115) mounted on plural boards (110),
each said module having an n-sided surface geometry for which the sides are substantially equal in length,
each said module having therewithin a multiplicity of internal circuit paths interconnecting multiple chips,
each of the edges of each module comprising a discrete plurality of circuit path terminations selectively connecting to circuits in said multiple chips, the edges thereby constituting n-ports to said module,
said ports of each module having a nominal sequential assigned set (Q,N,S,E,W) of successive edge positions, including two positions (E,W) reserved to accept communications linkages from a host computer, and
routing paths on said boards connecting said reserved ports,
said stacked multiprocessor board array being characterized in that the specific physical location of each said routing path on each of said boards is determined by
reordering the nominal locations of the ports of each said module so that said two ports reserved for communication linkages are adjacent on each module, and
successively rotating each said module to cause the now-adjacent reserved ports to face inwardly toward each other and a common board area.

7. An array in accordance with claim 6, wherein "n" has a value of five or six.

8. An array in accordance with claim 6 or 7, comprising:
a Host computer (50),
a communications access path (60) from said Host computer disposed in a vertical run to a center location of said hoard, and
communications links (116) from said access path to each said module.

## Patentansprüche

1. Gestapelte Multiprozessor-Leiterplattenanordnung mit mehreren, auf mehreren Leiterplatten (70, 80, 90, 100) angebrachten Multichipmodulen (1-16), wobei jedes der besagten Module eine im wesentlichen rechteckige Oberflächengeometrie aufweist und in dem besagten Modul eine Mehrzahl interner Leitungszüge mehrere Chips miteinander verbindet, wobei jeder der vier Ränder jedes Moduls eine diskrete Mehrzahl von Leitungszug-Abschlüssen (18) umfaßt, die selektiv Verbindungen zu Schaltungen in den besagten mehreren Chips bereitstellen, und die Ränder dadurch Nord- (N-), Ost- (O-), Süd- (S-) und West- (W-) Ports zu dem besagten Modul bilden, und die besagten Ports jedes Moduls im Uhrzeigersinn genommen eine nominell zugewiesene Randposition von Nord, Ost, Süd und West aufweisen und Signalführungswege (37-40) die Ost- und West-Ports der besagten Module verbinden, und Signalführungswege (29-32) die Nord- und Süd-Ports der besagten Module verbinden, wobei die besagte gestapelte Multiprozessor-Leiterplattenanordnung dadurch gekennzeichnet ist, daß die spezifische physikalische Lage jedes besagten Signalführungswegs auf jeder der besagten mehreren Leiterplatten bestimmt wird, indem die nominellen Nord-, Ost-, Süd- und West-Ports jedes besagten Moduls umgeordnet werden, so daß die Ost- und West-Ports auf jedem Modul nebeneinander liegen, und nacheinander jedes besagte Modul gedreht wird, um zu bewirken, daß die nunmehr nebeneinander liegenden Ost- und West-Ports nach innen aufeinander und auf einen gemeinsamen Leiterplattenbereich zeigen.

2. Anordnung nach Anspruch 1, wobei die Anzahl der besagten auf jeder besagten Leiterplatte angebrachten Module vier ist.

3. Anordnung nach Anspruch 2, die folgendes umfaßt:
eine gemeinsame Kommunikationsbusstruktur für die besagten vier Module, wobei sich die besagte Struktur bei dem besagten gemeinsamen Innenbereich der besagten Leiterplatte befindet und folgendes umfaßt:
eine Kommunikationszugangsweggruppe (60), die unter einer der besagten Ost-West-Portverbindungen (39) und in den besagten gemeinsamen Bereich auf der besagten Leiterplatte geführt wird, und
Mittel, die parallele Wege (66, 69) im Inneren der besagten Ost-West-Portverbindungen umfassen, um die besagte Zugangsweggruppe bis zu jedem einer der besagten Module zu verlängern.

4. Anordnung nach Anspruch 2 oder 3, die eine Mehrzahl von Signalführungswegen umfaßt, die auf den besagten Leiterplatten zwischen den Nord- und Süd-Ports benachbarter Module ausgebildet sind.

5. Anordnung nach Anspruch 2 oder 3, wobei die Positionen zweier der besagten Module (7, 8) bezüglich ihrer nominellen Ursprungsposition vertauscht sind.

6. Gestapelte Multiprozessor-Leiterplattenanordnung mit folgendem:
mehreren Multichipmodulen (111-115), die auf mehreren Leiterplatten (110) angebracht sind, wobei
jedes besagte Modul eine n-seitige Oberflächengeometrie aufweist, bei der die Seiten im wesentlichen die gleiche Länge aufweisen,
sich in jedem besagten Modul eine Mehrzahl interner Leitungszüge befindet, die mehrere Chips miteinander verbinden,
jeder der Ränder jedes Moduls eine diskrete Mehrzahl von Leitungszug-Abschlüssen umfaßt, die selektiv Verbindungen zu Schaltungen in den besagten mehreren Chips bereitstellen, und die Ränder dadurch n-Ports zu dem besagten Modul bilden,
die besagten Ports jedes Moduls eine nominelle, sequentielle zugewiesene Menge (Q, N, S, O, W) aufeinanderfolgender Randpositionen aufweist, die zwei Positionen (O, W) enthält, die für die Aufnahme von Kommunikationsverbindungen von einem Hostcomputer reserviert sind, und
Signalführungswegen auf den besagten Leiterplatten, die die besagten reservierten Ports verbinden,
wobei die besagte gestapelte Multiprozessor-Leiterplattenanordnung dadurch gekennzeichnet ist, daß die spezifische physikalische Lage jedes besagten Signalführungswegs auf jeder der besagten Leiterplatten bestimmt wird, indem
die nominellen Lagen der Ports auf jedem besagten Modul umgeordnet werden, so daß die besagten beiden Ports, die für Kommunikationsverbindungen reserviert sind, auf jedem Modul nebeneinander liegen, und
nacheinander jedes besagte Modul gedreht wird, um zu bewirken, daß die nunmehr benachbarten reservierten Ports nach innen aufeinander und auf einen gemeinsamen Leiterplattenbereich zeigen.

7. Anordnung nach Anspruch 6, wobei "n" einen Wert von fünf oder sechs aufweist.

8. Anordnung nach Anspruch 6 oder 7 mit:
einem Hostcomputer (50),
einem Kommunikationszugangsweg (60), der von dem besagten Hostcomputer aus in einem vertikalen Verlauf zu einer Mittenposition auf der besagten Leiterplatte angeordnet ist, und
Kommunikationsverbindungen (116) von dem besagten Zugangsweg zu jedem besagten Modul.

## Revendications

1. Arrangement de circuits multiprocesseur empilés comprenant plusieurs modules multipuce (1 à 16) montés sur plusieurs circuits (70, 80, 90, 100), chaque dit module ayant une géométrie de surface substantiellement rectangulaire et, à l'intérieur dudit module, une multiplicité de trajets de circuits internes interconnectant des puces multiples, chacun des quatre bords de chaque module comprenant une pluralité discrète de terminaisons de trajets de circuits (18) se connectant sélectivement à des circuits dans lesdites puces multiples, les bords constituant ainsi des ports nord (N), est (E), sud (S) et ouest (O) vers ledit module, et lesdits ports de chaque module ayant une position de bord assignée nominale de nord, est, sud et ouest, en allant dans le sens des aiguilles d'une montre, et des trajets d'acheminement (37 à 40) connectant les ports est et ouest desdits modules, et des trajets d'acheminement (29 à 32) connectant les ports nord et sud desdits modules, ledit arrangement de circuits multiprocesseur empilés étant caractérisé en ce que l'emplacement physique spécifique de chaque dit trajet d'acheminement sur chacun desdits plusieurs circuits est déterminé en réagençant les ports nord, est, sud et ouest nominaux de chaque dit module de telle sorte que les ports est et ouest soient adjacents sur chaque module, et en tournant successivement chaque dit module pour amener les ports est et ouest maintenant adjacents à s'orienter vers l'intérieur l'un face à l'autre et sur une zone de circuit commune.

2. Arrangement selon la revendication 1, dans lequel le nombre desdits modules montés sur chaque dit circuit est de quatre.

3. Arrangement selon la revendication 2, comprenant :
une structure de bus de communications commune auxdits quatre modules, ladite structure étant située au niveau de ladite zone intérieure commune dudit circuit et comprenant :
un groupe de trajets d'accès de communications (60) acheminé sous l'une desdites connexions de ports est-ouest (39) et à l'intérieur de ladite zone commune sur ledit circuit, et
un moyen comprenant des trajets parallèles (66,69) intérieurs par rapport auxdites connexions de ports est-ouest pour étendre ledit groupe de trajets d'accès vers chacun d'un desdits modules.

4. Arrangement selon la revendication 2 ou 3, comprenant une pluralité de trajets d'acheminement formés sur lesdits circuits entre les ports nord et sud de modules adjacents.

5. Arrangement selon la revendication 2 ou 3, dans lequel les positions de deux desdits modules (7,8) sont échangées par rapport à leurs positions initiales nominales.

6. Arrangement de circuits multiprocesseur empilés comprenant :
plusieurs modules multipuce (111 à 115) montés sur plusieurs circuits (110),
chaque dit module ayant une géométrie de surface à n côtés pour laquelle les côtés sont substantiellement de longueur égale,
chaque dit module comportant une multiplicité de trajets de circuits internes interconnectant des puces multiples,
chacun des bords de chaque module comprenant une pluralité discrète de terminaisons de trajets de circuits se connectant sélectivement à des circuits dans lesdites puces multiples, les bords constituant ainsi n ports vers ledit module,
lesdits ports de chaque module ayant un ensemble nominal assigné séquentiellement (Q, N, S, E, O) de positions de bords successives, dont deux positions (E, O) réservées pour accepter des liaisons de communications provenant d'un ordinateur hôte, et
des trajets d'acheminement sur lesdits circuits connectant lesdits ports réservés,
ledit arrangement de circuits multiprocesseur empilés étant caractérisé en ce que l'emplacement physique spécifique de chaque dit trajet d'acheminement sur chacun desdits circuits est déterminé en
réagençant les emplacements nominaux des ports de chaque dit module de telle sorte que lesdits deux ports réservés aux liaisons de communications soient adjacents sur chaque module, et
en tournant successivement chaque dit module pour amener les ports réservés maintenant adjacents à s'orienter vers l'intérieur l'un face à l'autre et vers une zone de circuit commune.

7. Arrangement selon la revendication 6, dans lequel "n" a une valeur de cinq ou six.

8. Arrangement selon la revendication 6 ou 7, comprenant :
un ordinateur hôte (50),
un trajet d'accès de communications (60) à partir dudit ordinateur hôte disposé dans une ligne verticale par rapport à un emplacement central dudit circuit, et
des liaisons de communications (116) à partir dudit trajet d'accès vers chaque dit module.
